# EUROPÄISCHE PATENTANMELDUNG

(11) **EP 1 273 676 A2**
(43) Veröffentlichungstag der Anmeldung: **08.01.2003**
(21) Anmeldenummer: 02013237.9
(22) Anmeldetag: 17.06.2002
(51) Int. Cl.: C23C 14/32, C23C 14/06, B65D 65/42, C23C 14/00

(54) **Verfahren zur Herstellung von gas- und flüssigkeitsundurchlässigen Schichten auf einem Substrat**

(30) Priorität: 28.06.2001 DE 10130666
(71) Anmelder: Applied Films GmbH & Co. KG, 63755 Alzenau (DE)
(72) Erfinder: Krempel-Hesse, Jörg, Dr., 63683 Ortenberg-Eckartsborn (DE); Liehr, Michael, Dr., 36325 Feldatal (DE); Hacker, Volker, 63674 Altenstadt-Oberau (DE); Sommer, Elisabeth, Dr., 63755 Alzenau (DE); Grimm, Helmut, Dr., 64291 Darmstadt (DE)
(74) Vertreter: Schickedanz, Willi, Dr. Dipl.-Ing.

(57) **Zusammenfassung**

Die Erfindung betrifft ein Verfahren zur Herstellung von gas- und flüssigkeitsundurchlässigen Schichten auf einem Substrat, die eine relativ hohe Elastizität besitzen. Diese Elastizität wird durch die Einlagerung von Kohlenstoff in eine Schicht aus einem Metall- oder Halbleiteroxid erreicht. Um zu einer solchen Einlagerung zu kommen, wird ein Metall- oder Halbleiter mittels einer Bogenentladung ionisiert. Sodann wird ein Reaktivgas, z. B. O₂, zugeführt, mit dem das ionisierte Metall bzw. der ionisierte Halbleiter ein Oxid bildet. Außerdem wird ein kohlenstoffhaltiges Gas beigegeben, das seinen Kohlenstoff freigibt, sodass sich auf dem Substrat eine Oxidschicht bildet, in der Kohlenstoff eingeschlossen ist.

## Beschreibung

Die Erfindung betrifft ein Verfahren zur Herstellung von gas- und flüssigkeitsun

durchlässigen Schichten auf einem Substrat

Die für Verpackungen oder als Behälter üblicherweise verwendeten Kunststoffe sind in aller Regel nicht hinreichend diffusionsdicht für flüchtige Substanzen wie Kohlenstoffe oder Aromen und Duftstoffe sowie gegenüber Gasen wie Kohlenwasserstoff, Sauerstoff, Kohlendioxid und Wasserdampf. Dieses macht sich insbesondere bei dünnwandigen Verpackungen, wie z. B. Folien oder unter Gasdruck stehenden Verpackungen, welche z. B. CO₂-haltige Erfrischungsgetränke enthalten, besonders nachteilig bemerkbar.

Es ist deshalb bekannt, Kunststoffverpackungen mit Diffusionsbarriereschichten zu versehen. Optisch transparente Barriereschichten werden in bekannter Weise durch Aufdampfen von Metalloxiden, meist Al₂O₃ oder unterstöchiometrisches Siliziumoxid, SiO_{X}, auf die Substratoberflächen hergestellt.

Alternativ werden auch quarzähnliche SiO₂-Schichten durch einen plasmachemischen Gasphasenabscheidungsprozess ("Plasma Enhanced Chemical Vapor Deposition", PECVD) aus einer Organosiliziumverbindung mit einem Überschuss an Sauerstoff hergestellt, wie der Veröffentlichung J. T. Felts: Transparent Gas Barrier Technologies", Society of Vacuum Coaters 33rd Ann. Tech. Conf. Proc. (1990), S. 184 bis 193, und der EP 0 299 754 B1 zu entnehmen ist. Die Mittels PECVD-Verfahren hergestellten SiO₂-Schichten weisen gegenüber aufgedampften SiOₓ-Schichten eine höhere optische Transparenz und eine deutlich verbesserte Sperrwirkung und auch Reißfestigkeit auf.

Nachteilig ist bei reinen SiO₂- oder SiOₓ-Schichten indessen, dass sie recht spröde sind und leicht reißen.

Es wurde deshalb bereits vorgeschlagen, mittels verschiedener Verfahren in diese Schichten Kohlenstoff einzubauen (DE 44 04 690 A1, DE 44 38 359 A1, DE 198 02 506 A1, DE 198 02 333 A1), um hierdurch die Schichten elastischer zu machen. Die meisten Verfahren lassen jedoch keine schnelle Beschichtung großer Mengen zu, die beispielsweise bei der Beschichtung von klarsichtigen Kunststoff-Getränkeflaschen erforderlich ist. Dies gilt z. B. für das häufig eingesetzte PECVD-Verfahren (WO 99/19229) und für das CVD-Verfahren (US 5 641 559).

Außerdem ist bei den genannten Verfahren nachteilig, dass infolge des relativ hohen Prozessgasdruckes von üblicherweise angewendeten 0,1 bis 1 mbar während des Beschichtungsprozesses starke Verunreinigungen in der Beschichtungsanlage und in den Vakuumanlagen entstehen. Diese Verunreinigungen bedingen einen hohen Reinigungs- und Wartungsaufwand. Weiterhin ist nachteilig, dass verfahrensbedingt komplex aufgebaute und sehr kostenaufwändige Edukte zum Einsatz gebracht werden müssen, die nach einem "Crackprozess" im Plasma zuerst in die zur Schichterzeugung erforderlichen Bausteine zerlegt werden müssen.

Es ist außerdem ein Verfahren zur Materialbeschichtung bekannt, bei dem das zu beschichtende Material in einer Unterdruckkammer Materialdampf ausgesetzt wird, der mittels einer Bogenentladung erzeugt wird (EP 0 158 972 B1). Hierbei wird das zu verdampfende Material mit der Anode einer Spannungsquelle verbunden.

Der Erfindung liegt die Aufgabe zugrunde, mit Hilfe einer Bogenentladung kohlenstoffhaltige Beschichtungen auf Substraten herzustellen.

Diese Aufgabe wird gemäß den Merkmalen des Patentanspruchs 1 gelöst.

Die Erfindung betrifft im Einzelnen ein Verfahren zur Herstellung einer Schicht und ein damit herstellbares Schichtsystem mit einem plasmagestützten Gasphasenabscheideverfahren, wobei diese Schicht einen erhöhten Kohlenstoffanteil enthält und ausschließlich oder zustäzlich zu den bekannten transparenten Barriereschichten für Kunststofffolien und Kunststoffbehälter verwendet wird. Der zusätzliche Kohlenstoff stammt aus einem kohlenstoffhaltigen Medium, dass sich bei der Plasmaentladung im Vakuum im gasförmigen Zustand befindet und den Kohlenstoff durch z. B. Ionisierung freigibt. Das Verfahren kann bei relativ geringen Drücken durchgeführt werden, dadurch entstehen sehr wenige den Betrieb der Anlage störende Verunreinigungen. Außerdem können als Kohlenstoffträger sehr kostengünstige kurzkettige Silikonöle oder kurzkettige Kohlenwasserstoffverbindungen eingesetzt werden, die eine Synthese der Schicht aus einfachen und billigen Ausgangsmaterialien ermöglichen. Der zusätzlich eingebaute Kohlenstoff bewirkt vorrangig eine Verbesserung der Elastizität der Schicht.

Der mit der Erfindung erzielte Vorteil besteht insbesondere darin, dass eine schnelle Beschichtung ermöglicht wird und die Verunreinigungen deutlich verringert werden.

Außerdem hemmt das erfindungsgemäße Verfahren die Permeation von gasförmigen und/oder flüssigen Stoffen, insbesondere von Kohlenwasserstoffen, Sauerstoff, Wasserdampf und von CO₂ durch das beschichtete Substrat.

Weiterhin wird erfindungsgemäß zusätzlich zu den beim anodischen Arc-Verdampfen üblicherweise eingesetzten Ausgangsmaterialien, einschließlich des Kathodenmaterials, für das erforderliche kohlenstoffhaltige und im Vakuum gasförmige Trägermedium des in die Barriereschicht einzubringenden Kohlenstoffs ein kostengünstiges Edukt, vorzugsweise kurzkettige Silikonöle, z. B. HMDSO (Hexamethyldisiloxan), TMDS (Tetramethyldisiloxan) und deren Derivate oder kurzkettige Kohlenwasserstoffverbindungen mit Einfach-, Zweifach- und Dreifachbindungen, z. B. Methan, Ethan, Ethen oder Acetylen eingesetzt. Durch den Einsatz dieser einfachen und nicht kostenintensiven Ausgangsprodukte kann die Herstellung und der Aufbau der kohlenstoffhaltigen Schicht in Form einer Synthese, d. h. gezielte Zuführung der erforderlichen Komponenten für die zu erzeugende Barriereschicht als Moleküle und Atome aus den vorrangigen Bestandteilen Sauerstoff, Silizium und Kohlenstoff, viel ökonomischer erfolgen, als es bisher möglich war.

Die Erfindung verbessert auch wesentlich die Wirkung solcher Barriereschichten auf Hohlkörpern aus Kunststoff, die verstärkten thermischen Belastungszyklen unterliegen, z. B. höheren Temperaturen und höheren relativen Luftfeuchtigkeiten, sowie auch deren Resistenz gegenüber abrasiven Beanspruchungen, was sich z. B. in automatischen Abfüllanlagen besonders auf die Haltbarkeit der Schicht günstig auswirkt.

Das erfindungsgemäße Verfahren wird anhand der nachfolgend beschriebenen Zeichnungen erläutert. Es zeigen:
- Fig. 1: eine Beschichtungsanlage
- Fig. 2: ein Substrat mit einer kohlenstoffreichen Barriereschicht
- Fig. 3: ein Substrat mit einer kohlenstoffreichen und einer konventionellen Barriereschicht
- Fig. 4: ein Substrat mit drei Schichten.

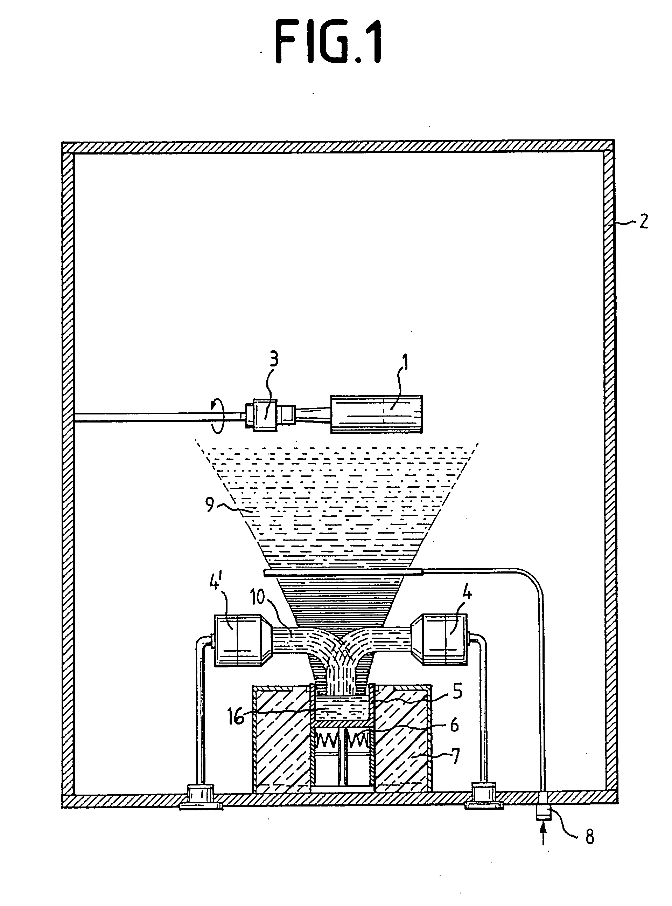

In der Fig. 1 ist das Prinzip einer Beschichtungsanlage gezeigt, mit welcher das erfindungsgemäße Verfahren durchgeführt wird. Diese Beschichtungsanlage weist eine Vakuumbehandlungskammer 2 auf, in der sich eine drehbare Aufnahmevorrichtung 3 für einen zu beschichtenden Hohlkörper 1 befindet.

Bei diesem Hohlkörper kann es sich um eine klarsichtige Kunststoffflasche handeln.

Unterhalb dieses Hohlkörpers 1 befindet sich eine Gaszuführung 8, über die ein kohlenstoffhaltiges Gas und gegebenenfalls ein Reaktivgas in die Vakuumbehandlungskammer 2 eingeführt wird. Unterhalb des horizontal verlaufenden Teils der Gaszuführung befinden sich zwei Elektroden 4', 4, die vorzugsweise an dem negativen Potenzial einer nicht dargestellten Spannungsquelle liegen. Unterhalb dieser Elektroden 4', 4, bei denen es sich um Magnesiumelektroden handeln kann, befindet sich ein Verdampfungstiegel 5, der in einer Heizung 6 aufgeheizt werden kann und in dem sich ein zu verdampfendes Beschichtungsmaterial 16 befindet. Um den Verdampfungstiegel 5 und um die Heizung 6 herum ist eine thermische Isolierung 7 vorgesehen. Der Beschichtungsabstand beträgt etwa 25 bis 50 cm.

Wird eine Gleichspannung von z. B. 24 Volt bei einer Bogenleistung von einigen kW zwischen die Elektroden 4, 4' und den Verdampfungstiegel 5 gelegt, bildet sich bei geeignetem Material im Tiegel 5 und bei geeignetem Abstand zwischen den Elektroden 4, 4' und dem Beschichtungsmaterial 16 im Tiegel 5 eine Bogenentladung 10 aus. Um eine sichere Entzündung der Bogenentladung zu erreichen, kann auch zu Beginn eine an sich bekannte Zündhilfe verwendet werden, beispielsweise in Form eines Zündstifts, der an positivem Potenzial liegt, oder durch die Erzeugung eines Plasmas oberhalb des zu verdampfenden Materials mit an sich bekannten Mitteln.

Durch die Bogenentladung 10 wird das Beschichtungsmaterial 16 im Verdampfungstiegel 5 verdampft und ionisiert. Es bildet sich somit oberhalb des Verdampfungstiegels eine ionisierte Verdampfungskeule aus. Handelt es sich bei dem verdampften Material beispielsweise um Silizium und wird über die Gaszuführung 8 ein Gemisch aus O₂ und HMDSO eingegeben, so verbindet sich das Silizium mit dem Sauerstoff und das HMDSO dissoziiert und setzt Kohlenstoff frei. Auf den rotierenden Hohlkörper 1 gelangt dann ein Gemisch aus Kohlenstoff und SiO₂- oder SiOₓ und bildet dort eine Schicht, die transparent ist und fest haftet. Die Haftung wird durch physikalische und/oder chemische Bindekräfte zwischen dem SiO₂ bzw. SiOₓ und dem Kohlenstoff bewirkt. Der Einschluss des Kohlenstoffs kann je nach Materialart und -menge zu verschiedenen Matrizen führen.

Bei größeren Materialmengen im Verdampfungstiegel kann es vorkommen, dass die Bogenentladung 10 allein nicht ausreicht, um eine Verdampfung herbeizuführen. In diesem Fall wird die Heizung 6 als zusätzliches Aufheizmittel zugeschaltet.

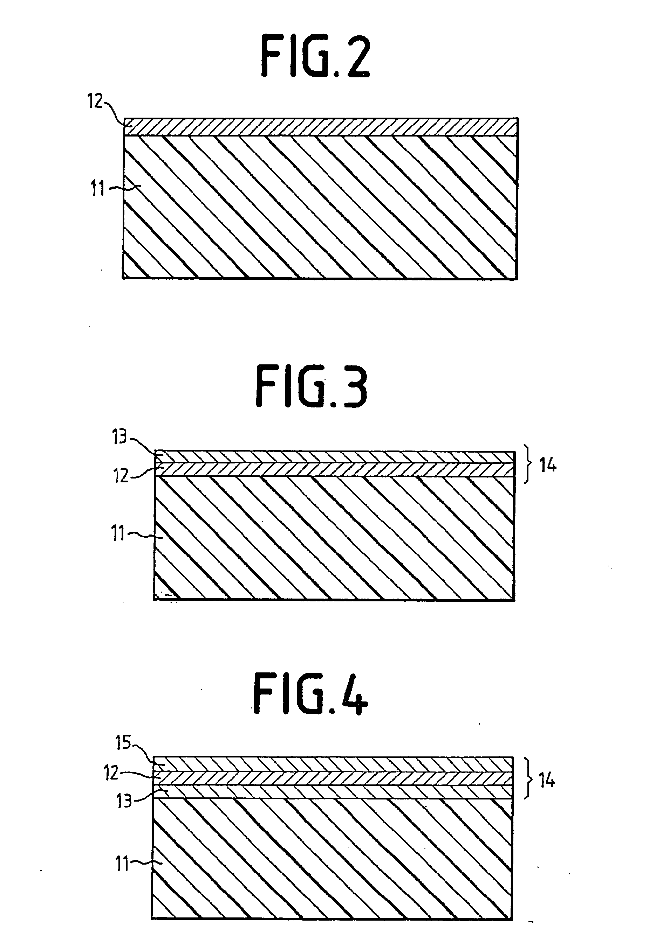

Die Fig. 2 zeigt ein Substrat 11, auf dem mit dem vorbeschriebenen Verfahren eine kohlenstoffreiche Schicht 12 aufgebracht wurde.

In der Fig. 3 ist ein Substrat 11 mit zwei Schichten dargestellt, wobei die erste Schicht 12 wieder eine kohlenstoffreiche Schicht und die zweite Schicht 13 eine Standardschicht, z. B. aus SiO₂ oder SiOₓ ist. Die zweite Schicht kann mit der in Fig. 1 dargestellten Anlage ebenfalls aufgebracht werden.

Die Fig. 4 zeigt ein Substrat 11, auf dem drei Schichten 13, 12, 15 aufgebracht sind, wobei die erste Schicht 13 eine übliche Standardbarriereschicht, z. B. aus SiO₂ ist, die zweite Schicht 12 eine kohlenstoffreiche Schicht und die dritte Schicht 15 eine Schutzschicht ist.

Zwischen dem Substrat 11 und der ersten Schicht 12 oder 13 kann noch eine Basisschicht eingebracht sein.

Die alternierende Beschichtung mit Standardschicht und kohlenstoffreicher Schicht kann beliebig wiederholt werden, wobei mit jeder Schichtart als erste Schicht auf dem Substrat begonnen werden kann.

Weiterhin ist es möglich, wahlweise zusätzlich eine erste Basisschicht und/oder abschließend eine obere Deckschicht mit jeweils einer anderen Schichtmatrix aufzubringen. Unter einer Matrix wird hierbei ein Material verstanden, das einen anderen Stoff eingeschlossen hält, z. B. SiO, das C einschließt. Die Art dieses Einschlusses kann verschieden sein, und zwar in Abhängigkeit von den verwendeten Materialien, deren Konzentration und von den Abständen zwischen dem Verdampfungstiegel, der Gaszuführung und dem Substrat.

Obwohl das Verfahren vorzugsweise mit Hilfe einer Gleichstrom-Bogenentladung durchgeführt wird, kann auch eine Wechselstrom-Bogenentladung verwendet werden.

## Patentansprüche

1. Verfahren zur Herstellung von gas- und flüssigkeitsundurchlässigen Schichten auf einem Substrat, **gekennzeichnet durch** folgende Schritte:
a) es wird eine Bogenentladung zwischen einer Elektrode (4, 4') und einem Beschichtungsmaterial (16) erzeugt;
b) in dem Raum zwischen dem Beschichtungsmaterial (16) und dem Substrat (1) wird Kohlenstoff oder eine kohlenstoffhaltige Verbindung eingebracht.

2. Verfahren nach Anspruch 1, **dadurch gekennzeichnet, dass** außer dem Kohlenstoff oder der kohlenstoffhaltigen Verbindung ein Reaktivgas eingebracht wird.

3. Verfahren nach den Ansprüchen 1 und 2, **dadurch gekennzeichnet, dass** das Reaktivgas und der Kohlenstoff oder die kohlenstoffhaltige Verbindung gemeinsam und an der gleichen Stelle eingebracht werden.

4. Verfahren nach den Ansprüchen 1 und 2, **dadurch gekennzeichnet, dass** das Reaktivgas an einer anderen Stelle eingebracht wird als der Kohlenstoff oder die kohlenstoffhaltige Verbindung.

5. Verfahren nach Anspruch 1, **dadurch gekennzeichnet, dass** das Beschichtungsmaterial mindestens ein Metall, eine Metallverbindung, ein Halbleiter oder eine Halbleiterverbindung ist.

6. Verfahren nach Anspruch 5, **dadurch gekennzeichnet, dass** das Metall Aluminium ist.

7. Verfahren nach Anspruch 5, **dadurch gekennzeichnet, dass** der Halbleiter Silizium ist.

8. Verfahren nach Anspruch 1, **dadurch gekennzeichnet, dass** die kohlenstoffhaltige Verbindung ein Gas ist.

9. Verfahren nach Anspruch 1 oder Anspruch 8, **dadurch gekennzeichnet, dass** die kohlenstoffhaltige Verbindung ein kurzkettiges Silikonöl enthält, z. B. HMDSO (Hexamethyldisiloxan) und/oder TMDS (Tetramethyldisiloxan) und/oder deren Derivate und/oder kurzkettige Kohlenwasserstoffverbindungen mit Einfach-, Zweifachund/oder Dreifachverbindungen, z. B. Methan, Ethan, Ethen und Acetylen.

10. Verfahren nach Anspruch 1, **dadurch gekennzeichnet, dass** das Beschichtungsmaterial (16) mittels einer Heizung (6) erwärmt wird.

11. Verfahren nach Anspruch 1, **dadurch gekennzeichnet, dass** das Beschichtungsmaterial (16) mittels einer Heizung (6) zum Verdampfen gebracht wird.

12. Verfahren nach Anspruch 1, **dadurch gekennzeichnet, dass** es bei einem Prozessdruck im Bereich von 1 x 10⁻⁴ bis 5 x 10⁻³ mbar durchgeführt wird.

13. Verfahren nach Anspruch 1, **dadurch gekennzeichnet, dass** die Bogenentladung mittels einer Gleichspannung erzeugt wird, wobei die Elektrode an Minuspotenzial und das Beschichtungsmaterial an Pluspotenzial liegt.

14. Verfahren nach Anspruch 1, **dadurch gekennzeichnet, dass** die Bogenentladung mittels einer Wechselspannung erzeugt wird.

15. Verfahren nach Anspruch 1, **dadurch gekennzeichnet, dass** das Substrat aus Kunststoff besteht.

16. Verfahren nach Anspruch 1, **dadurch gekennzeichnet, dass** eine erste Bogenentladung zwischen einer ersten Elektrode (4) und dem Beschichtungsmaterial (16) und einer zweiten Bogenentladung zwischen einer zweiten Elektrode (4') und dem Beschichtungsmaterial (16) erfolgt.

17. Verfahren nach Anspruch 1 und Anspruch 2, **dadurch gekennzeichnet, dass** das Beschichtungsmaterial (16) durch die Bogenentladung verdampft und ionisiert wird, dass ferner das ionisierte Beschichtungsmaterial mit dem Reaktivgas Verbindungen eingeht und dass diese Verbindungen zusammen mit Kohlenstoff oder Kohlenstoffverbindungen eine Schicht auf dem Substrat bilden.

18. Verfahren nach Anspruch 17, **dadurch gekennzeichnet, dass** das Reaktivgas O₂ ist.

19. Verfahren nach Anspruch 17, **dadurch gekennzeichnet, dass** die Schicht einen Kohlenstoffanteil von 2,5 % bis 15 % aufweist.

20. Verfahren nach Anspruch 1, **dadurch gekennzeichnet, dass** auf dem Substrat (1) nur eine kohlenstoffhaltige Schicht (12) aufgebracht wird.

21. Verfahren nach Anspruch 1, **dadurch gekennzeichnet, dass** auf dem Substrat (1) zuerst eine kohlenstoffhaltige Schicht (12) und hierauf eine kohlenstoffarme Standardbarriereschicht (13) aufgebracht wird.

22. Verfahren nach Anspruch 1, **dadurch gekennzeichnet, dass** auf dem Substrat zuerst eine kohlenstoffarme Standardbarriereschicht (13), hierauf eine kohlenstoffhaltige Schicht (12) und sodann eine äußere Schutzschicht aufgebracht wird.

23. Verfahren nach Anspruch 21 oder Anspruch 22, **dadurch gekennzeichnet, dass** die kohlenstoffarme Standardbarriereschicht ein Oxid von Si, Al, Mg oder Cr ist.

24. Verfahren nach Anspruch 21, **dadurch gekennzeichnet, dass** die Schichten für Licht durchlässig sind.

25. Verfahren nach Anspruch 1, **dadurch gekennzeichnet, dass** die Schichten für Mikrowellen durchlässig sind.
